# EUROPEAN PATENT APPLICATION

(11) **EP 2 911 193 A1**
(43) Date of publication of application: **26.08.2015**
(21) Application number: 13847105.7
(22) Date of filing: 20.06.2013
(51) Int. Cl.: H01L 23/40, H01L 23/473, H01L 25/07, H01L 25/18, H05K 7/20

(54) **COOLING STRUCTURE AND HEAT GENERATING BODY**

(30) Priority: 16.10.2012 JP 2012228625
(71) Applicant: Fuji Electric Co., Ltd., Kawasaki-shi, Kanagawa 210-9530 (JP)
(72) Inventor: TANAKA, Yasuhito, Kawasaki-shi Kanagawa 210-9530 (JP); ABE, Shinichi, Kawasaki-shi Kanagawa 210-9530 (JP)
(74) Representative: Appelt, Christian W.
(86) International application number: PCT/JP2013/003863
(87) International publication number: WO 2014/061178

(57) **Abstract**

A first heat generating body (11), a cooling body 3, which is joined to one surface of the first heat generating body, second heat generating bodies (22, 23), and heat transfer plates (32, 33), which transfer the heat of the second heat generating bodies to the cooling body, are provided, wherein the first heat generating body is surface-to-surface joined to the cooling body by a first junction surface (3d), and the heat transfer plates are surface-to-surface joined to the cooling body by a second junction surface (3c) which does not overlap the first junction surface.

## Description

### Technical Field

The present invention relates to a cooling structure including a heat generating body and a cooling body which cools heat generated in the heat generating body, and to the heat generating body.

### Background Art

As a cooling structure including a heat generating body and a cooling body, a power conversion device described in PTL 1 is known.

The power conversion device is configured so that a water cooling jacket (a cooling body) through which a cooling liquid passes is disposed in a housing, and a power module (a heat generating body) in which are incorporated IGBTs acting as semiconductor switching elements for power conversion is disposed on the water cooling jacket, thus cooling the power module. Also, in the housing, a control circuit substrate is disposed on the opposite side of the power module from the water cooling jacket so as to keep a predetermined distance from the power module, thus adopting a configuration such that heat generated in the control circuit substrate is transferred via a heat release member to a metal base plate supporting the control circuit substrate, and furthermore, the heat transferred to the metal base plate is transferred to the water cooling jacket via sidewalls of the housing which support the metal base plate.

The heretofore known example described in PTL 1 adopts a configuration such that the heat generated in the control circuit substrate is released through a path from the control circuit substrate through the heat release member, the metal base plate, and the housing to the water cooling jacket. Because of this, as good heat transfer properties are required of the housing, too, by utilizing the housing as one portion of the heat transfer path, a material is limited to a metal with high thermal conductivity, and with a power conversion device of which a reduction in size and weight is required, there is fear that it is impossible to select a light material, such as a resin, and it is thus difficult to reduce the weight.

Therefore, a structure wherein the end portions of the metal base plate are clamped between the power module and the water cooling jacket, thereby efficiently releasing heat generated in a heat generating body, such as the control circuit substrate, to the water cooling jacket without going through the housing, is conceivable.

At this time, shouldered clamping surfaces on which are disposed the end portions of the metal base plate are formed on the outer peripheral sides of the junction surfaces of the power module and water cooling jacket.

### Citation List

### Patent Literature

PTL 1: JP-A-2010-35346

### Summary of Invention

### Technical Problem

However, there is a problem in terms of processing cost in that the clamping surfaces are formed one on each of the power module and water cooling jacket. In particular, in order to form the clamping surface on the junction surface of the water cooling jacket, it is difficult to handle the water cooling jacket, which is a large and heavy object, when processing the water cooling jacket mounted on a processing machine, and there is fear that the processing cost increases.

Also, as a configuration is adopted wherein the metal base plate having a predetermined thickness is clamped between the water cooling jacket and the power module, a shoulder is provided on the water cooling jacket around a liquid-tight seal portion, taking into account the thickness of the metal base plate, and so on, in order to make reliable the sealing performance of the liquid-tight seal portion which hermetically seals in the cooling water of the water cooling jacket, thus resulting in a complicated configuration.

The invention, having been contrived focusing attention on the heretofore described unsolved problems of the heretofore known example, has for its object to provide a cooling structure, and a heat generating body, wherein it is possible to enhance the efficiency of cooling the heat generating body, and to reduce processing cost by adopting a simple configuration.

### Solution to Problem

In order to achieve the object, a cooling structure according to an aspect of the invention includes a first heat generating body; a cooling body which is joined to one surface of the first heat generating body; second heat generating bodies; and heat transfer plates which transfer the heat of the second heat generating bodies to the cooling body, wherein the first heat generating body is surface-to-surface joined to the cooling body by a first junction surface, and the heat transfer plates are surface-to-surface joined to the cooling body by a second junction surface which does not overlap the first junction surface.

According to the cooling structure of the aspect, as the first heat generating body is surface-to-surface joined to the cooling body by the first junction surface, it is possible to efficiently cool the first heat generating body. Also, as the second heat generating bodies are surface-to-surface joined to the cooling body via the heat transfer plates, it is possible to efficiently cool the second heat generating bodies. Furthermore, as it is possible to provide the first and second junction surfaces in respective positions on the cooling body which do not overlap each other, and thus form a flat junction surface, it is possible to reduce processing cost.

Also, the cooling structure according to the aspect of the invention may be configured so that the heat transfer plates each have formed thereon a bend portion wherein the end portion on a side of the heat transfer plate which is joined to the second junction surface is bent, and the bend portions are surface-to-surface joined to the cooling body.

According to the cooling structure of the aspect, it is possible to enhance the heat transfer efficiency between the heat transfer plates and the cooling body.

Also, a cooling structure according to an aspect of the invention may be configured so as to include a semiconductor power module on one surface of which a heat release member is formed; a cooling body which is surface-to-surface joined to the heat release member; and heat transfer plates which transfer the heat of mounting substrates, on each of which are mounted circuit parts including heat generating circuit parts which drive the semiconductor power module, to the cooling body, wherein the heat release member is cooled by direct cooling by a cooling liquid flowing through the cooling body, and has a liquid-tight seal portion provided between the junction surfaces of the heat release member and cooling body, and the heat transfer plates are surface-to-surface joined to a junction surface of the cooling body which does not overlap the liquid-tight seal portion.

According to the cooling structure of the aspect, as the heat release member is cooled by the cooling body by a direct cooling method, it is possible to efficiently cool the semiconductor power module. Also, as the mounting substrates are surface-to-surface joined to the cooling body via the heat transfer plates, it is possible to efficiently cool the mounting substrates. Furthermore, as a simple configuration is adopted wherein the heat transfer plates are surface-to-surface joined to the junction surface of the cooling body which does not overlap the liquid-tight seal portion, it is possible to reduce processing cost.

Also, a cooling structure according to an aspect of the invention may be configured so as to include a semiconductor power module on one surface of which a heat release member is formed; a cooling body which is surface-to-surface joined to the heat release member; substrates each supported keeping a predetermined distance from the semiconductor power module; and heat transfer plates which support the substrates and transfer the heat of the substrates to the cooling body, wherein the heat release member is cooled by direct cooling by a cooling liquid flowing through the cooling body, and has a liquid-tight seal portion provided between the junction surfaces of the heat release member and cooling body, and the heat transfer plates are surface-to-surface joined to a junction surface of the cooling body which does not overlap the liquid-tight seal portion.

According to the cooling structure of the aspect, as the heat release member is cooled by the cooling body by a direct cooling method, it is possible to efficiently cool the semiconductor power module. Also, as the substrates are surface-to-surface joined to the cooling body via the heat transfer plates, the substrates are efficiently cooled while being reliably supported. Furthermore, as a simple configuration is adopted wherein the heat transfer plates are surface-to-surface joined to the junction surface of the cooling body which does not overlap the liquid-tight seal portion, it is possible to reduce processing cost.

Also, the cooling structure according to the aspect of the invention may be configured so that the junction surface of the cooling body to which the heat transfer plates are surface-to-surface joined is a surface outside the liquid-tight seal portion.

According to the cooling structure of the aspect, it is possible to reduce processing cost by making the junction surface of the cooling body, to which the heat transfer plates are surface-to-surface joined, a surface outside the liquid-tight seal portion.

Also, the cooling structure according to the aspect of the invention may be configured so that the heat transfer plates each have formed thereon a bend portion wherein the end portion on a side of the heat transfer plate which is joined to the cooling body is bent, and the bend portions are surface-to-surface joined to the junction surface of the cooling body.

According to the cooling structure of the aspect, it is possible to enhance the heat transfer efficiency between the heat transfer plates and the cooling body.

Also, a heat generating body according to an aspect of the invention includes a first heat generating body which is surface-to-surface joined to the cooling body by a first junction surface; second heat generating bodies; and heat transfer plates which transfer the heat of the second heat generating bodies and are surface-to-surface joined to the cooling body by a second junction surface which does not overlap the first junction surface.

According to the heat generating body of the aspect, it is possible to enhance the efficiency of cooling the heat generating body with the cooling body, and as a simple junction surface is provided by adopting a structure wherein the heat transfer plates are joined to the cooling body by the first and second junction surfaces of the cooling body which do not overlap each other, it is possible to reduce processing cost.

Also, the heat generating body according to the aspect of the invention may be configured so that the heat transfer plates each have formed thereon a bend portion wherein the end portion on a side of the heat transfer plate which is joined to the second junction surface is bent, and the bend portions are surface-to-surface joined to the cooling body.

According to the heat generating body of the aspect, it is possible to enhance the heat transfer efficiency between the heat transfer body and the cooling body.

Also, a heat generating body according to an aspect of the invention, being a heat generating body which is joined to a cooling body, may be configured so as to include a semiconductor power module on one surface of which a heat release member is formed; mounting substrates on each of which are mounted circuit parts including heat generating circuit parts which drive the semiconductor power module; and heat transfer plates which transfer the heat of the mounting substrates to the cooling body, wherein the heat release member is cooled by direct cooling by a cooling liquid flowing through the cooling body, and has a liquid-tight seal portion provided between the junction surfaces of the heat release member and cooling body, and the heat transfer plates are surface-to-surface joined to a junction surface of the cooling body which does not overlap the liquid-tight seal portion.

According to the heat generating body of the aspect, it is possible to enhance the efficiency of cooling the semiconductor power module and the mounting substrates with the cooling body, and as a simple junction surface is provided on the cooling body, it is possible to reduce processing cost.

Furthermore, a heat generating body according to an aspect of the invention may be configured so as to include a semiconductor power module on one surface of which a heat release member is formed; substrates each supported keeping a predetermined distance from the semiconductor power module; and heat transfer plates which support the substrates and transfer the heat of the substrates to the cooling body, wherein the heat release member is cooled by direct cooling by a cooling liquid flowing through the cooling body, and has a liquid-tight seal portion provided between the junction surfaces of the heat release member and cooling body, and the heat transfer plates are surface-to-surface joined to a junction surface of the cooling body which does not overlap the liquid-tight seal portion.

According to the heat generating body of the aspect, it is possible to enhance the efficiency of cooling the semiconductor power module and the substrates with the cooling body, and as a simple junction surface is provided on the cooling body, it is possible to reduce processing cost.

Furthermore, the heat generating body according to the aspect of the invention may be configured so that the junction surface of the cooling body to which the heat transfer plates are surface-to-surface joined is a surface outside the liquid-tight seal portion.

According to the heat generating body of the aspect, it is possible to reduce processing cost by making the junction surface of the cooling body, to which the heat transfer plates are surface-to-surface joined, a surface outside the liquid-tight seal portion.

Still furthermore, the heat generating body according to the aspect of the invention may be configured so that the heat transfer plates each have formed thereon a bend portion wherein the end portion on a side of the heat transfer plate which is joined to the junction surface of the cooling body outside the liquid-tight seal portion is bent, and the bend portions are surface-to-surface joined to the cooling body.

According to the heat generating body of the aspect, it is possible to provide a heat generating body which is further enhanced in the heat transfer efficiency with the cooling body.

### Advantageous Effects of Invention

According to the cooling structure and heat generating body of the invention, it is possible to enhance the efficiency of cooling the heat generating body, and it is possible to reduce processing cost by adopting a simple configuration.

### Brief Description of Drawings

[Fig. 1] Fig. 1 is a sectional view showing a power conversion device of a first embodiment according to the invention.
[Fig. 2] Fig. 2 is a sectional view showing a main portion of the power conversion device of the first embodiment.
[Fig. 3] Fig. 3 is a sectional view showing a structure in which a heat-transfer support metal plate and a cooling body are fixed.
[Fig. 4] Fig. 4 is a side view showing the heat-transfer support metal plate.
[Fig. 5] Fig. 5 is a diagram illustrating heat release paths of the power conversion device of the first embodiment.
[Fig. 6] Fig. 6 is a sectional view showing a power conversion device of a second embodiment according to the invention.

### Description of Embodiments

Hereafter, a detailed description will be given, while referring to the drawings, of modes for carrying out the invention (hereafter referred to as embodiments).

### [First Embodiment]

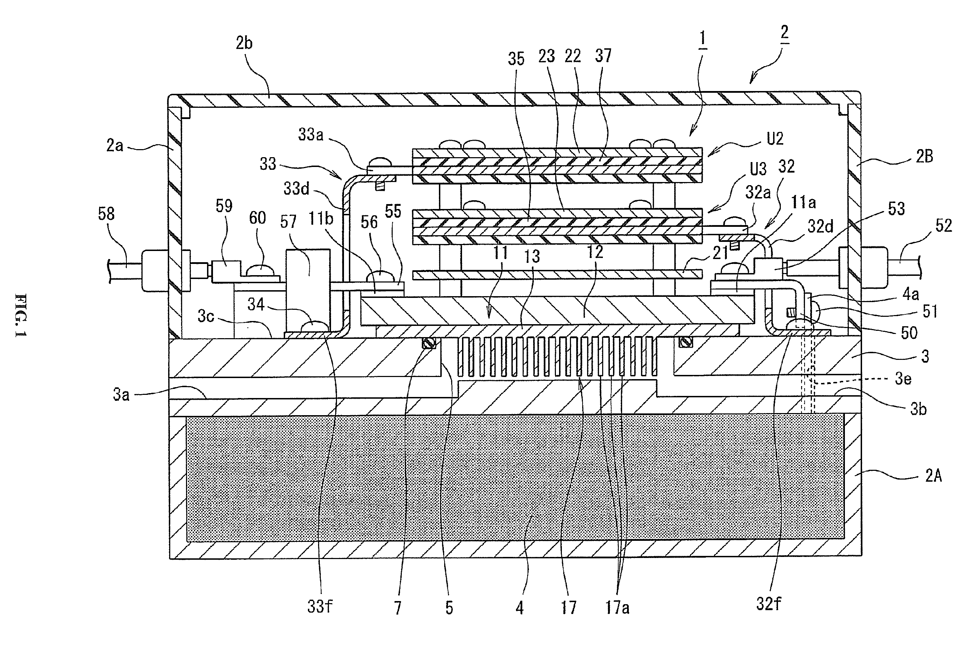

Fig. 1 shows an overall configuration of a first embodiment according to the invention.

Reference numeral 1 in Fig. 1 is a power conversion device, and the power conversion device 1 is housed in a housing 2. The housing 2, into which a synthetic resin is molded, is configured of a lower housing 2A and an upper housing 2B into which the housing 2 is divided with a cooling body 3, which has the configuration of a water cooling jacket, sandwiched therebetween.

The lower housing 2A is configured of a bottomed quadrangular cylindrical body. The open top of the lower housing 2A is covered with the cooling body 3, and a smoothing film capacitor 4 is housed inside the lower housing 2A.

The upper housing 2B includes an open-topped and -bottomed quadrangular cylindrical body 2a and a cover 2b which closes the top of the quadrangular cylindrical body 2a. Further, the bottom of the quadrangular cylindrical body 2a is closed with the cooling body 3.

Although not shown, a seal material is interposed between the bottom of the quadrangular cylindrical body 2a and the cooling body 3 by applying a liquid sealant, sandwiching in a rubber packing, or the like.

The cooling body 3, being formed by injection molding, for example, aluminum or aluminum alloy with high thermal conductivity, is such that the upper surface thereof is made a flat surface, and that a cooling water inlet 3a and outlet 3b open outwardly of the housing 2. The inlet 3a and outlet 3b are connected to an unshown cooling water supply source via, for example, a flexible hose.

An immersion portion 5, communicating with the inlet 3a and outlet 3b, which is opened in a quadrangular shape is formed in the center of the upper surface of the cooling body 3, a quadrangular frame-shaped peripheral groove 6 is formed around the peripheral edge of the top opening portion of the immersion portion 5, and an O-ring 7 is mounted in the peripheral groove 6.

To return to Fig. 1, an insertion hole 3e in which is vertically inserted a positive and negative insulation-coated electrode 4a of the film capacitor 4 held in the lower housing 2A is formed in the cooling body 3.

The power conversion device 1 includes a power module 11 in which, for example, insulated gate bipolar transistors (IGBTs) are incorporated as semiconductor switching elements configuring, for example, an inverter circuit for power conversion. The power module 11 has IGBTs incorporated in a flattened rectangular parallelepiped-shaped insulating casing 12, and a metal heat release member 13 is formed on the lower surface of the casing 12.

A wetted portion 17 to be put in the immersion portion 5 of the cooling body 3 is formed in the central portion of the lower surface of the heat release member 13, thus adopting a configuration such that the heat release member 13 is cooled by the cooling body 3 by a direct cooling method.

The wetted portion 17 is configured of a large number of cooling fins 17a which protrude a predetermined length from the lower surface of the heat release member 13 while being equally spaced from each other, thus adopting a configuration such that the large number of cooling fins 17a are immersed in cooling water flowing into the immersion portion 5 from the inlet 3a.

Insertion holes 15 in which to insert fixing screws 14 are formed in four corners, when viewed in plan, of the casing 12 and heat release member 13. Four substrate fixing portions 16 of a predetermined height are formed protruded in respective portions of the upper surface of the casing 12 on the inner sides of the insertion holes 15.

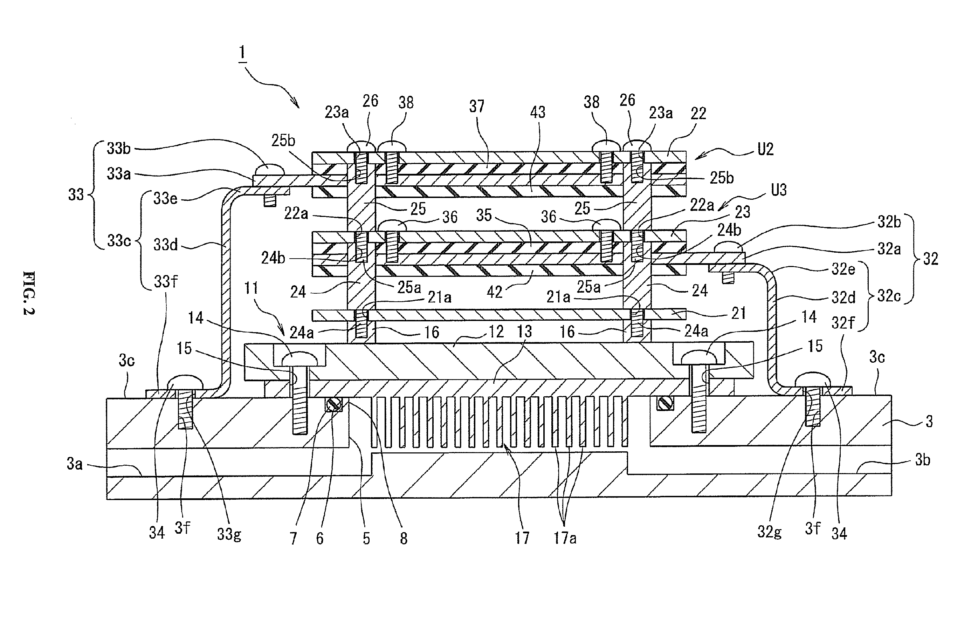

As shown in Fig. 2, a drive circuit substrate 21 on which is mounted a drive circuit which drives the IGBTs incorporated in the power module 11, or the like, is fixed to the upper ends of the substrate fixing portions 16. Also, a power circuit substrate 23 acting as a mounting substrate on which is mounted a power circuit which includes heat generating circuit parts and supplies a power source to the IGBTs incorporated in the power module 11, or the like, is fixed keeping a predetermined distance above the drive circuit substrate 21. Furthermore, a control circuit substrate 22 acting as a mounting substrate on which is mounted a control circuit which includes heat generating circuit parts with a relatively large heat generation amount or a relatively high heat generation density, and which controls the IGBTs incorporated in the power module 11, is fixed keeping a predetermined distance above the power circuit substrate 23.

The drive circuit substrate 21 is fixed by inserting externally threaded portions 24a of joining screws 24 into the insertion holes 21a formed in positions opposite to the substrate fixing portions 16, and threading the externally threaded portions 24a onto internally threaded portions 16a formed in the upper surfaces of the substrate fixing portions 16.

Also, the power circuit substrate 23 is fixed by inserting externally threaded portions 25a of joining screws 25 into insertion holes 22a formed in positions opposite to internally threaded portions 24b formed at the upper ends of the joining screws 24, and threading the externally threaded portions 25a onto the internally threaded portions 24b of the joining screws 24.

Furthermore, the control circuit substrate 22 is fixed by inserting fixing screws 26 into insertion holes 23a formed in positions opposite to internally threaded portions 25b formed at the upper ends of the joining screws 25, and threading the fixing screws 26 onto the internally threaded portions 25b of the joining screws 25.

Also, the control circuit substrate 22 and the power circuit substrate 23 are supported by heat-transfer support metal plates 32 and 33 so that the metal plates 32 and 33 uniquely form heat release paths to the cooling body 3 without going through the housing 2. The heat-transfer support metal plates 32 and 33 are formed of a metal plate with high thermal conductivity, for example, a metal plate of aluminum or aluminum alloy.

As shown in Fig. 2, the heat-transfer support member 32 is configured of a flat plate-like heat-transfer support plate portion 32a and a heat-transfer support side plate portion 32c fixed by a fixing screw 32b to the right end side of the heat-transfer support plate portion 32a along the long sides of the power module 11.

The power circuit substrate 23 is fixed to the heat-transfer support plate portion 32a by fixing screws 36 via a heat transfer member 35. The heat transfer member 35, being an elastic body having elasticity, is configured to external dimensions the same as those of the power circuit substrate 23. As the heat transfer member 35, a heat transfer member which is enhanced in heat transfer properties while exhibiting insulating performance by interposing a metal filler inside silicon rubber is applied.

The heat-transfer support side plate portion 32c is configured of a linking plate portion 32d extending in an up-down direction on the right end side along the long sides of the power module 11, an upper plate portion 32e, bent leftward from the upper end of the linking plate portion 32d, which is linked to the heat-transfer support plate portion 32a by the fixing screw 32b, and a lower plate portion 32f bent rightward from the lower end of the linking plate portion 32d. Further, an insertion hole 32g in which a fixing screw 34 is inserted is formed in the lower plate portion 32f of the heat-transfer support side plate portion 32c.

The heat-transfer support member 33 is configured of a flat plate-like heat-transfer support plate portion 33a and a heat-transfer support side plate portion 33c fixed by a fixing screw 33b to the left end side of the heat-transfer support plate portion 33a along the long sides of the power module 11.

The control circuit substrate 22 is fixed to the heat-transfer support plate portion 33a by fixing screws 38 via a heat transfer member 37 the same as the heat transfer member 35.

The heat-transfer support side plate portion 33c is configured of a linking plate portion 33d extending in the up-down direction on the left end side along the long sides of the power module 11, an upper plate portion 33e, bent rightward from the upper end of the linking plate portion 33d, which is linked to the heat-transfer plate portion 33a by a fixing screw 33b, and a lower plate portion 33f bent leftward from the lower end of the linking plate portion 33d. Further, an insertion hole 33g in which a fixing screw 34 is inserted is formed in the lower plate portion 33f of the heat-transfer support side plate portion 33c.

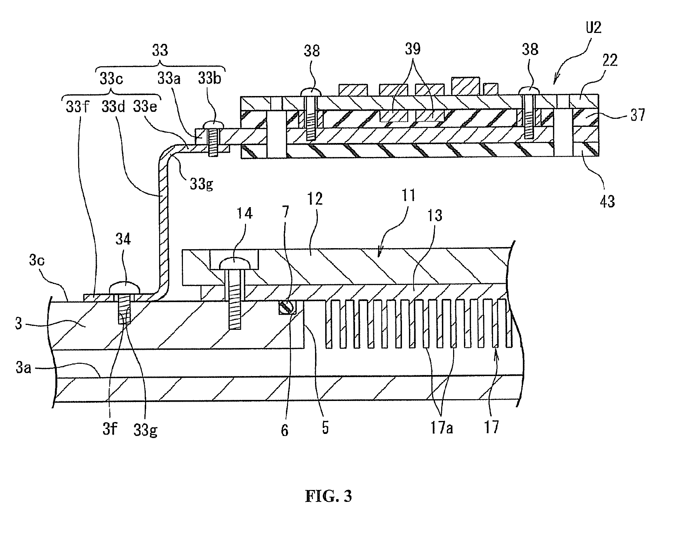

As shown in Fig. 3, heat generating circuit parts 39 are mounted on the lower surface side of the control circuit substrate 22, the control circuit substrate 22, heat transfer member 37, and heat-transfer support plate portion 33a are fixed in a stacked condition by the fixing screws 38, and in order to shorten an insulation distance, an insulating sheet 43 is stuck to the lower surface of the heat-transfer support plate portion 33a. These components in the stacked condition are called a control circuit unit U2.

At this time, the heat generating circuit parts 39 mounted on the lower surface side of the control circuit substrate 22 are embedded in the heat transfer member 37 by the elasticity of the heat transfer member 37. Because of this, as well as the contact of the heat generating circuit parts 39 with the heat transfer member 37 being carried out without excess or deficiency, a good contact of the heat transfer member 37 with the control circuit substrate 22 and heat-transfer support plate portion 33a is carried out, and it is thus possible to reduce the thermal resistance between the heat transfer member 37 and the control circuit substrate 22 and heat-transfer support plate portion 33a.

Also, although not shown, heat generating circuit parts are also mounted on the lower surface side of the power circuit substrate 23, the power circuit substrate 23, heat transfer member 35, and heat-transfer support plate portion 32a are fixed in a stacked condition by the fixing screws 36, and in order to shorten an insulation distance, an insulating sheet 42 is stuck to the lower surface of the heat-transfer support plate portion 32a. These components in the stacked condition are called a power circuit unit U3.

Further, the heat generating circuit parts mounted on the lower surface side of the power circuit substrate 23 are embedded in the heat transfer member 35 by the elasticity of the heat transfer member 35, as well as the contact of the power circuit substrate 23 with the heat transfer member 35 being carried out without excess or deficiency, a good contact of the heat transfer member 35 with the power circuit substrate 23 and heat-transfer support plate portion 32a, and it is thus possible to reduce the thermal resistance between the heat transfer member 35 and the power circuit substrate 23 and heat-transfer support plate portion 32a.

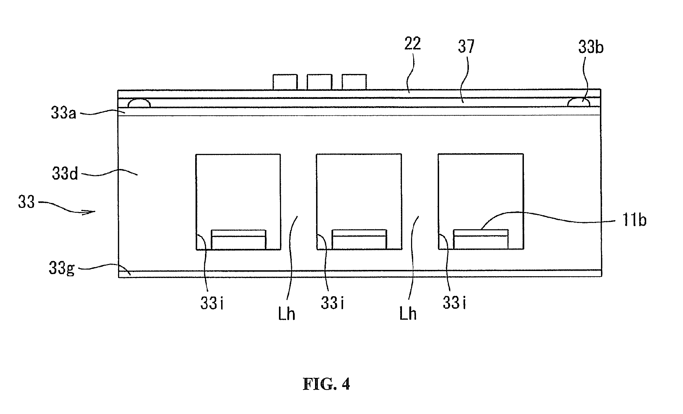

Also, as shown in Fig. 4, three insertion holes 33i which are, for example, quadrangular, in which are inserted busbars 55, to be described hereafter, are formed in positions on the linking plate portion 33d of the heat-transfer support metal plate 33 corresponding to three-phase alternating current output terminals 11b, shown in Fig. 1, of the power module 11. By forming the three insertion holes 33i in this way, it is possible to form comparatively wide heat transfer paths Lh, one between the adjacent insertion holes 33i, and thus possible to increase the total cross-sectional area of the heat transfer paths and efficiently transfer heat. Also, it is also possible to secure rigidity against vibration.

In the same way, the same insertion holes (not shown) are also formed in respective positions on the linking plate portion 32d of the heat-transfer support metal plate 32 corresponding to positive and negative terminals 11a of the power module 11.

Further, as shown in Fig. 2, the fixing screws 14 are inserted into the insertion holes 15 in the heat release member 13, and the fixing screws 14 are threaded onto internally threaded portions formed in the cooling body 3. Also, a plurality of externally threaded portions 3f are formed in an outer peripheral side plane 3c of the upper surface of the cooling body 3, and the insertion hole 32g formed in the lower plate portion 32f of the heat-transfer support metal plate 32 and the insertion hole 33g formed in the lower plate portion 33f of the heat-transfer support metal plate 33 are aligned with the externally threaded portions 3f. Further, the fixing screws 34 inserted in the insertion holes 32g and 33g are threaded onto the externally threaded portions 3f in the outer peripheral side plane 3c.

By so doing, the heat release member 13 is fixed to the cooling body 3, and the O-ring 7 mounted in the peripheral groove 6 around the immersion portion 5 of the cooling body 3 is crushed by the lower surface 13a of the heat release member 13, thus providing a liquid-tight seal which prevents cooling water accumulated in the immersion portion 5 of the cooling body 3 from leaking to the external, along with which the heat-transfer support metal plates 32 and 33 are fixed to the cooling body 3 in a condition in which the lower plate portions 32f and 33f are in surface-to-surface abutment with the outer peripheral side plate 3c.

Also, as shown in Fig. 1, the busbar 55 is connected to the positive and negative input terminal 11a of the power module 11, and the positive and negative electrode 4a of the film capacitor 4 which passes through the cooling body 3 is linked to the other end of the busbar 55 by a fixing screw 51. Also, a crimping terminal 53 fixed to the leading end of a connecting cord 52 connecting with an external converter (not shown) is fixed to the negative terminal 11a of the power module 11.

Furthermore, one end of the busbar 55 is connected to the three-phase alternating current output terminal 11b of the power module 11 by a fixing screw 56, and a current sensor 57 is disposed partway through the busbar 55. Further, a crimping terminal 59 is fixed to the other end of the busbar 55 by a fixing screw 60. The crimping terminal 59 is fixed to a motor connecting cable 58 connected to an external three-phase electric motor (not shown).

In this condition, direct current power is supplied from the external converter (not shown), and by placing a power circuit mounted on the power circuit substrate 23 and a control circuit mounted on the control circuit substrate 22 in an operating condition, a gate signal formed of, for example, a pulse width modulated signal is supplied to the power module 11 from the control circuit via a drive circuit mounted on the drive circuit substrate 21. By so doing, the IGBTs incorporated in the power module 11 is controlled, thus converting the direct current power to alternating current power. The converted alternating current power is supplied to the motor connecting cable 58 from the three-phase alternating current terminal 11b via the busbar 55, thus drive controlling the three-phase electric motor (not shown).

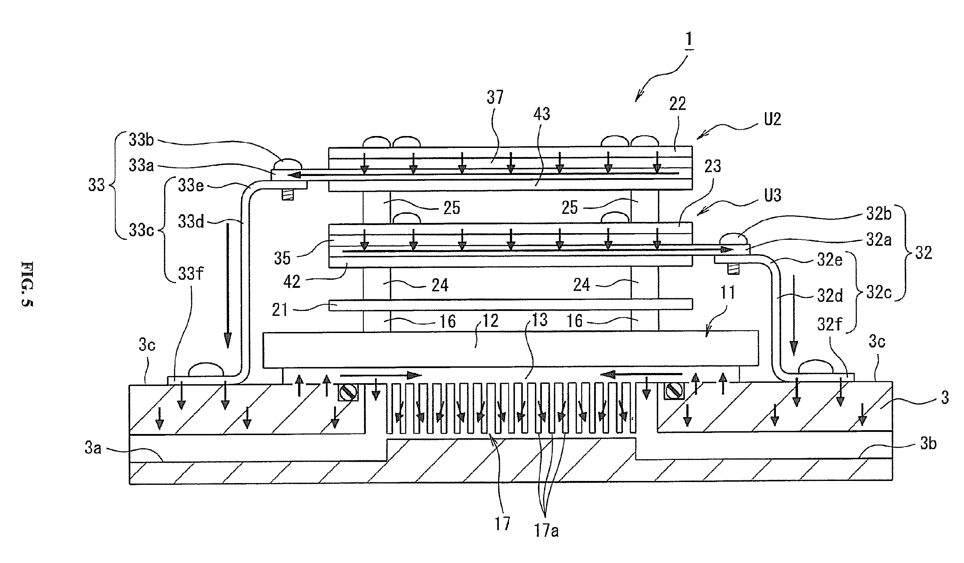

As shown in Fig. 5, at this time, heat is generated in the IGBTs incorporated in the power module 11, but the wetted portion 17 provided in the central portion of the lower surface of the heat release member 13 of the power module 11 is put in the immersion portion 5 provided in the cooling body 3 and immersed in a cooling liquid, meaning that the power module 11 is efficiently cooled.

Also, the heat generating circuit parts 39 are included in the control circuit and power circuit mounted on the control circuit substrate 22 and power circuit substrate 23, and heat is generated in the heat generating circuit parts 39. At this time, the heat generating circuit parts 39 are mounted on the lower surfaces sides of the control circuit substrate 22 and power circuit substrate 23.

Further, the heat-transfer support plate portions 32a and 33a of the heat-transfer support metal plates 32 and 33 are provided on the lower surface sides of the control circuit substrate 22 and power circuit substrate 23 via the elastic heat transfer members 35 and 37 with high thermal conductivity.

As shown in Fig. 5, heat transferred to the heat-transfer support metal plates 32 and 33 is released to the cooling body 3 from the lower plate portions 32f and 33f in direct surface-to-surface contact with the outer peripheral side plane 3c of the upper surface of the cooling body 3, thus carrying out efficient heat release from the heat-transfer support metal plates 32 and 33.

Herein, a first heat generating body according to the invention corresponds to the power module 11, a semiconductor power module according to the invention corresponds to the power module 11, second heat generating bodies according to the invention correspond to the control circuit substrate 22 and power circuit substrate 23, mounting substrates according to the invention correspond to the control circuit substrate 22 and power circuit substrate 23, substrates according to the invention correspond to the control circuit substrate 22 and power circuit substrate 23, heat transfer plates according to the invention correspond to the heat-transfer support metal plates 32 and 33, bend portions of the heat transfer plates according to the invention correspond to the lower plate portions 32f and 33f of the heat-transfer support metal plates 32 and 33, direct cooling according to the invention corresponds to the wetted portion 17 provided in the central portion of the lower surface of the heat release member 13 and to the immersion portion 5 provided in the cooling body 3, a liquid-tight seal portion according to the invention corresponds to the lower surface of the heat release member, the peripheral groove 6, and the O-ring 7, and a junction surface of the cooling body according to the invention corresponds to the outer peripheral side plane 3c which is the upper surface of the cooling body 3.

Consequently, according to the power conversion device of the embodiment, when the IGBTs incorporated in the power module 11 generate heat, the wetted portion 17 provided in the central portion of the lower surface of the heat release member 13 of the power module 11, being put in the immersion portion 5 provided in the cooling body 3 and immersed in the cooling liquid, is directly cooled, meaning that it is possible to efficiently cool the power module 11.

Also, as the lower plate portions 32f and 33f of the heat-transfer support metal plates 32 and 33 are surface-to-surface joined directly to the outer peripheral side plane 3c of the upper surface of the cooling body 3, heat transferred from the control circuit substrate 22 and power circuit substrate 23 to the heat-transfer support metal plates 32 and 33 is released to the cooling body 3 from the lower plate portions 32f and 33f, and it is thus possible to carry out efficient heat release.

Further, in a heretofore known device, shouldered clamping surfaces are formed on the outer peripheral side junction surfaces of a heat generating body and cooling body in order to clamp metal base plates (which correspond to the heat-transfer support metal plates 32 and 33 of the embodiment), but in the power conversion device of the embodiment, a structure wherein the lower plate portions 32f and 33f of the heat-transfer support metal plates 32 and 33 are surface-to-surface joined to the outer peripheral side plane 3c of the upper surface of the cooling body 3 is adopted, thereby eliminating the need to process portions of the heat release member 13 and the cooling body 3, which is a large and heavy object, to which to join the heat-transfer support metal plates 32 and 33, meaning that it is possible to reduce processing cost.

### [Second Embodiment]

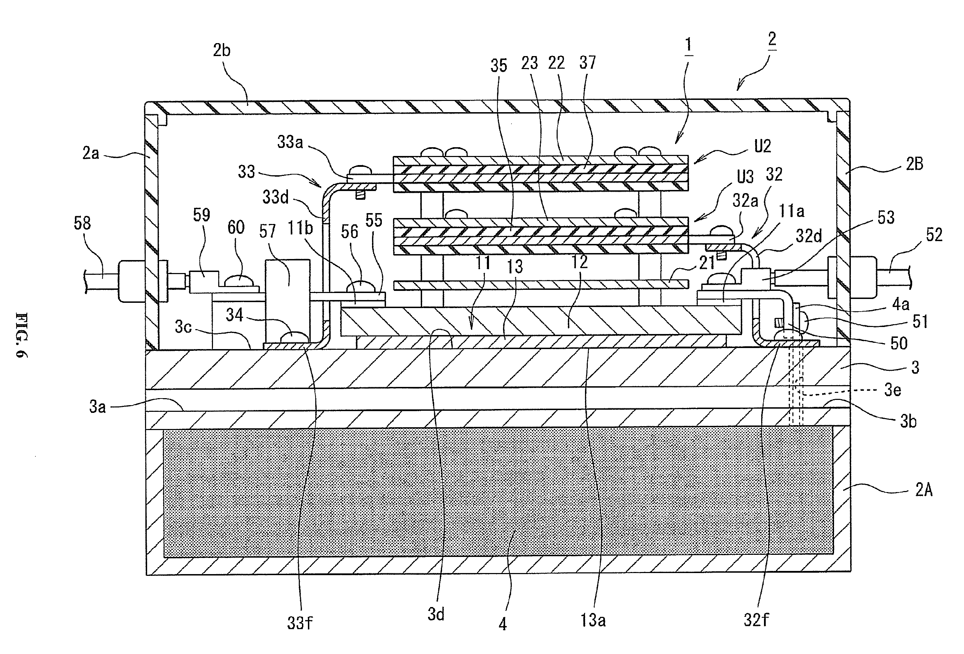

Next, Fig. 6 shows a power conversion device 1 of a second embodiment according to the invention. Components the same as those of the first embodiment shown in Fig. 1 and 2 are given the same signs, and a description thereof will be omitted.

The cooling body 3 of the second embodiment is configured so as to be cooled by the cooling body 3 by an indirect cooling method.

That is, the upper surface of the cooling body 3 of the second embodiment has a planar shape, and only the cooling water inlet 3a and outlet 3b open outwardly of the housing 2. The inlet 3a and outlet 3b are connected to an unshown cooling water supply source via, for example, a flexible hose.

The power module 11 is such that IGBTs are incorporated in the flattened rectangular parallelepiped-shaped insulating casing 12, and that the metal heat release member 13 is formed on the lower surface of the casing 12.

The lower surface 13a of the heat release member 13 has a planar shape and is in surface-to-surface abutment with a central side plane 3d of the upper surface of the cooling body 3.

The device of the second embodiment is such that heat is generated in the IGBTs incorporated in the power module 11, but that the lower surface 13a of the heat release member 13 of the power module 11 is surface-to-surface joined to the central side plane 3d of the cooling body 3, meaning that the power module 11 is efficiently cooled.

Also, as the heat-transfer support plate portions 32a and 33a of the heat-transfer support metal plates 32 and 33 are provided on the lower surface sides of the control circuit substrate 22 and power circuit substrate 23 via the elastic heat transfer members 35 and 37 with high thermal conductivity, heat, when generated in the heat generating circuit parts 39 mounted on the control circuit substrate 22 and power circuit substrate 23, is transferred to the heat-transfer support metal plates 32 and 33. Further, the heat transferred to the heat-transfer support metal plates 32 and 33 is released to the cooling body 3 from the lower plate portions 32f and 33f in direct surface-to-surface contact with the outer peripheral side plane 3c of the upper surface of the cooling body 3, meaning that efficient heat release from the heat-transfer support metal plates 32 and 33 is carried out.

Herein, a first junction surface according to the invention corresponds to the central side plane 3d of the upper surface of the cooling body 3, a second junction surface according to the invention corresponds to the outer peripheral side plane 3c of the upper surface of the cooling body 3, a first heat generating body according to the invention corresponds to the power module 11, a semiconductor power module according to the invention corresponds to the power module 11, second heat generating bodies according to the invention correspond to the control circuit substrate 22 and power circuit substrate 23, mounting substrates according to the invention correspond to the control circuit substrate 22 and power circuit substrate 23, substrates according to the invention correspond to the control circuit substrate 22 and power circuit substrate 23, heat transfer plates according to the invention correspond to the heat-transfer support metal plates 32 and 33, bend portions of the heat transfer plates according to the invention correspond to the lower plate portions 32f and 33f of the heat-transfer support metal plates 32 and 33.

Consequently, according to the power conversion device of the second embodiment, when the IGBTs incorporated in the power module 11 generates heat, the lower surface 13a of the heat release member 13 of the power module 11 is indirectly cooled by being surface-to-surface joined to the central side plane 3d of the cooling body 3, meaning that it is possible to efficiently cool the power module 11.

Also, as the lower plate portions 32f and 33f of the heat-transfer support metal plates 32 and 33 are surface-to-surface joined directly to the outer peripheral side plane 3c of the upper surface of the cooling body 3, heat transferred to the heat-transfer support metal plates 32 and 33 from the control circuit substrate 22 and power circuit substrate 23 is released to the cooling body 3 from the lower plate portions 32f and 33f, and it is thus possible to carry out efficient heat release.

Further, the cooling body 3 of the second embodiment is formed in a shape wherein the flat central side plane 3d and outer peripheral side plane 3c are provided on the upper surface of the cooling body 3, and the heat release member 13 is also formed in a shape wherein the flat lower surface 13a is provided, thus eliminating the need to process the portions of the heat release member 13 and the cooling body 3, which is a large and heavy object, to which to join the heat-transfer support metal plates 32 and 33, meaning that it is possible to reduce processing cost.

In the first and second embodiments, a structure wherein the lower plate portions 32f and 33f of the heat-transfer support metal plates 32 and 33 are surface-to-surface joined to the outer peripheral side plane 3c of the upper surface of the cooling body 3 has been adopted, but the scope of the invention not being limited to this, a structure wherein the lower plate portions 32f and 33f are surface-to-surface joined to the lower surface of the cooling body 3 may be adopted, or a structure wherein the lower plate portions 32f and 33f are surface-to-surface joined to the side surfaces of the cooling body 3.

Also, in the control circuit unit U2 and power circuit unit U3 illustrated in the first and second embodiments, a description has been given of a case in which the heat transfer members 35 and 37 are formed in the same outer shape as the control circuit substrate 22 and power circuit substrate 23. However, the invention, not being limited to the heretofore described configuration, may be configured so that the heat transfer members 35 and 37 are provided in only portions in which the heat generating circuit parts 39 exist.

Also, in the first and second embodiments, a description has been given of a case in which the heat generating circuit parts 39 are mounted on the rear surface sides of the control circuit substrate 22 and power circuit substrate 23 which are on the heat transfer members 35 and 37 sides. However, the invention is not limited to the heretofore described configuration. That is, a configuration may be such that the heat generating circuit parts 39 are mounted in outer peripheral regions on the opposite sides of the control circuit substrate 22 and power circuit substrate 23 from the heat transfer members 35 and 37.

Also, in the first and second embodiments, a description has been given of a case in which the film capacitor 4 is applied as a smoothing capacitor, but the invention not being limited to this, a configuration may be such that a cylindrical electrolytic capacitor is applied.

Also, a description has been given of a case in which the power conversion device 1 according to the invention is applied to an electric vehicle, but the invention, not being limited to this, can also be applied to a railroad vehicle running on a rail, and can be applied to any electrically driven vehicle. Furthermore, the power conversion device 1 not being limited to application to an electrically driven vehicle, it is possible to apply the power conversion device 1 of the invention in the case of driving an actuator such as an electric motor in other industrial equipment.

Furthermore, in the first and second embodiments, the lower plate portions 32f and 33f of the heat-transfer support metal plates 32 and 33 are bent in a direction away from the power module 11, but as long as regions of the upper surface of the cooling body 3 to which to surface-to-surface join the lower plate portions 32f and 33f are secured, a structure may be such that the lower plate portions 32f and 33f are bent in a direction toward the power module 11.

Still furthermore, when the heat-transfer support metal plates 32 and 33 are each formed of a component of an integrated structure, it is possible to reduce thermal resistance and carry out more efficient heat release, and it is possible to support the control circuit substrate 22 and power circuit substrate 23 while improving the resistance against vertical vibration, horizontal oscillation, or the like.

### Industrial Applicability

As above, the cooling structure according to the invention is useful for achieving a reduction in processing cost by enhancing the efficiency of cooling the heat generating body and adopting a simple configuration.

### Reference Signs List

1 ··· Power conversion device, 2 ··· Housing, 2A ··· Lower housing, 2B ··· Upper housing, 2a ··· Quadrangular cylindrical body, 2b ··· Cover, 3 ··· Cooling body, 3a ··· Inlet, 3b ··· Outlet, 3c ··· Outer peripheral side plane of upper surface of cooling body, 3d ··· Central side plane of upper surface of cooling body, 3e ··· Insertion hole, 3f ··· Externally threaded portion, 4 ··· Film capacitor, 4a ··· Positive and negative electrode, 5 ··· Immersion portion, 6 ··· Peripheral groove, 7 ··· O-ring, 8 ··· O-ring holding protrusion, 11 ··· Power module, 11a ··· Negative terminal, 11b ··· Three-phase alternating current output terminal, 12 ··· Casing, 13 ··· Heat release member, 13a ··· Lower surface of heat release member, 14 ··· Fixing screw, 15 ··· Insertion hole, 16 ··· Substrate fixing portion, 16a ··· Internally threaded portion, 17 ··· Wetted portion, 17a ··· Cooling fins, 21 ··· Drive circuit substrate, 21a ··· Insertion hole, 22 ··· Control circuit substrate, 22a ··· Insertion hole, 23 ··· Power circuit substrate, 23a ··· Insertion hole, 24a ··· Externally threaded portion, 24b ··· Internally threaded portion, 25a ··· Externally threaded portion, 25b ··· Internally threaded portion, 32, 33 ··· Heat-transfer support metal plate, 32a ··· Heat-transfer support plate portion, 32b ··· Fixing screw, 32c ··· Heat-transfer support side plate portion, 32d ··· Linking plate portion, 32e ··· Upper plate portion, 32f ··· Lower plate portion, 32g ··· Insertion hole, 33a ··· Heat-transfer support plate portion, 33b ··· Fixing screw, 33c ··· Heat-transfer support side plate portion, 33d ··· Lining plate portion, 33e ··· Upper plate portion, 33f ··· Lower plate portion, 33g ··· Insertion hole, 33i ··· Insertion hole, 34 ··· Fixing screw, 35 ··· Heat transfer member, 37 ··· Heat transfer member, 39 ··· Heat generating circuit part, 42 ··· Insulating sheet, 43 ··· Insulating sheet, 51 ··· Fixing screw, 52 ··· Connecting cord, 53, 59 ··· Crimping terminal, 55 ··· Busbar, 57 ··· Current sensor, 58 ··· Motor connecting cable, 60 ··· Fixing screw

## Claims

1. A cooling structure comprising:
a first heat generating body;
a cooling body which is joined to one surface of the first heat generating body;
second heat generating bodies; and
heat transfer plates which transfer the heat of the second heat generating bodies to the cooling body, the cooling structure being **characterized in that**
the first heat generating body is surface-to-surface joined to the cooling body by a first junction surface, and
the heat transfer plates are surface-to-surface joined to the cooling body by a second junction surface which does not overlap the first junction surface.

2. The cooling structure according to claim 1, **characterized in that**
the heat transfer plates each have formed thereon a bend portion wherein the end portion on a side of the heat transfer plate which is joined to the second junction surface is bent, and the bend portions are surface-to-surface joined to the cooling body.

3. A cooling structure comprising:
a semiconductor power module on one surface of which a heat release member is formed;
a cooling body which is surface-to-surface joined to the heat release member; and
heat transfer plates which transfer the heat of mounting substrates, on each of which are mounted circuit parts including heat generating circuit parts which drive the semiconductor power module, to the cooling body, the cooling structure being **characterized in that**
the heat release member is cooled by direct cooling by a cooling liquid flowing through the cooling body, and has a liquid-tight seal portion provided between the junction surfaces of the heat release member and cooling body, and
the heat transfer plates are surface-to-surface joined to a junction surface of the cooling body which does not overlap the liquid-tight seal portion.

4. A cooling structure comprising:
a semiconductor power module on one surface of which a heat release member is formed;
a cooling body which is surface-to-surface joined to the heat release member;
substrates each supported keeping a predetermined distance from the semiconductor power module; and
heat transfer plates which support the substrates and transfer the heat of the substrates to the cooling body, the cooling structure being **characterized in that**
the heat release member is cooled by direct cooling by a cooling liquid flowing through the cooling body, and has a liquid-tight seal portion provided between the junction surfaces of the heat release member and cooling body, and
the heat transfer plates are surface-to-surface joined to a junction surface of the cooling body which does not overlap the liquid-tight seal portion.

5. The cooling structure according to claim 3 or 4, **characterized in that**
the junction surface of the cooling body to which the heat transfer plates are surface-to-surface joined is a surface outside the liquid-tight seal portion.

6. The cooling structure according to claim 3 or 4, **characterized in that**
the heat transfer plates each have formed thereon a bend portion wherein the end portion on a side of the heat transfer plate which is joined to the cooling body is bent, and the bend portions are surface-to-surface joined to the junction surface of the cooling body.

7. A heat generating body which is joined to a cooling body, **characterized by** comprising:
a first heat generating body which is surface-to-surface joined to the cooling body by a first junction surface;
second heat generating bodies; and
heat transfer plates which transfer the heat of the second heat generating bodies and are surface-to-surface joined to the cooling body by a second junction surface which does not overlap the first junction surface.

8. The heat generating body according to claim 7, **characterized in that**
the heat transfer plates each have formed thereon a bend portion wherein the end portion on a side of the heat transfer plate which is joined to the second junction surface is bent, and the bend portions are surface-to-surface joined to the cooling body.

9. A heat generating body which is joined to a cooling body, comprising:
a semiconductor power module on one surface of which a heat release member is formed;
mounting substrates on each of which are mounted circuit parts including heat generating circuit parts which drive the semiconductor power module; and
heat transfer plates which transfer the heat of the mounting substrates to the cooling body, the heat generating body being **characterized in that**
the heat release member is cooled by direct cooling by a cooling liquid flowing through the cooling body, and has a liquid-tight seal portion provided between the junction surfaces of the heat release member and cooling body, and
the heat transfer plates are surface-to-surface joined to a junction surface of the cooling body which does not overlap the liquid-tight seal portion.

10. A heat generating body which is joined to a cooling body, comprising:
a semiconductor power module on one surface of which a heat release member is formed;
substrates each supported keeping a predetermined distance from the semiconductor power module; and
heat transfer plates which support the substrates and transfer the heat of the substrates to the cooling body, the heat generating body being **characterized in that**
the heat release member is cooled by direct cooling by a cooling liquid flowing through the cooling body, and has a liquid-tight seal portion provided between the junction surfaces of the heat release member and cooling body, and
the heat transfer plates are surface-to-surface joined to a junction surface of the cooling body which does not overlap the liquid-tight seal portion.

11. The heat generating body according to claim 9 or 10, **characterized in that**
the junction surface of the cooling body to which the heat transfer plates are surface-to-surface joined is a surface outside the liquid-tight seal portion.

12. The heat generating body according to claim 9 or 10, **characterized in that**
the heat transfer plates each have formed thereon a bend portion wherein the end portion on a side of the heat transfer plate which is joined to the junction surface of the cooling body outside the liquid-tight seal portion is bent, and the bend portions are surface-to-surface joined to the cooling body.
